Europäisches Patentamt

European Patent Office

Office européen des brevets

(11) Publication number: **0 628 918 A2**

# EUROPEAN PATENT APPLICATION

(21) Application number: 94303661.6

(22) Date of filing: 23.05.94

(51) Int. Cl.5: **G06F 15/20**

(30) Priority: **11.06.93 GB 9312053**

(43) Date of publication of application:
**14.12.94 Bulletin 94/50**

(84) Designated Contracting States:
**DE FR GB**

(71) Applicant: **INTERNATIONAL BUSINESS
MACHINES CORPORATION
Old Orchard Road
Armonk, N.Y. 10504 (US)**

(72) Inventor: **Simmons, John**

13 Parkway Gardens,
Chandler's Ford
Eastleigh, Hampshire S05 2EN (GB)
Inventor: **Todd, Stephen James Paul**
10 Christchurch Road
Winchester, Hampshire S023 9SR (GB)

(74) Representative: **Burt, Roger James, Dr.
IBM United Kingdom Limited
Intellectual Property Department
Hursley Park
Winchester Hampshire SO21 2JN (GB)**

(54) **A data processing system.**

(57) The present invention relates to a data processing system and method of operation, and in particular to a data processing system for creating drive signals to control an output device, wherein the drive signals created are dependent on the state of a model defined within the data processing system. The data processing system is characterised by the combination of several elements, including: a modelling application in which a model is defined, the model having a plurality of input variables associated therewith; a modification means to determine initial values for the input variables; and a model output means for generating the drive signals for the output device based on a state of the model, the state being dependent on the values of said input variables. The modification means is adapted to randomly adjust the values of the input variables within predetermined limits, and to insert the adjusted values into the modelling application to alter the state of the model. Further the data processing system is programmed to repeat a selected number of times, the generation of drive signals based on states of the model as altered by the modification means. The system also includes a comparison means for sending the successive drive signals generated by the data processing system to the output device. Once this has been done the modification means uses judgement information input by the user to determine a new set of initial values for the input variables, and the data processing system then repeats the generation of successive drive signals based on this new set of initial values.

FIG.1

The present invention relates to a data processing system and method of operation, and in particular to a data processing system for creating drive signals to control an output device, wherein the drive signals created are dependent on the state of a model defined within the data processing system.

Typically such a data processing system will run a software application in which a model can be defined by a number of equations, variables and constants. For example a spreadsheet application could be used to model the financial state of a company over a number of years. The state of the model might depend on a large number of variables, and typically the model will be responsive to information about those variables input into the model, such information being used to alter the state of the model.

Likewise, running the modelling application might result in a number of financial and other predictions indicating the success or otherwise of the modelling process. The user will generally wish to change a number of the input variables to produce a good set of predictions. However this is not always a straightforward task for the user.

The user's difficulty generally arises from the need to remember how the model variables were changed and the result of those changes, before the next set of changes can be made. Typically, graphs may be used to help in this visualisation process, eg. giving financial and market share results over a number of years. Even so, after a number of variable changes, the user's memory of the actual shape of the graphs will quickly fade, making it very difficult to choose the optimum direction to change the values of the input variables.

Existing modelling applications have included various tools to help in this modelling control process. One example is that of the built-in "solver". If the user is trying to achieve a specific result, eg. 'X' UK pounds revenue, this type of tool can usually vary many input variables without user interaction in an attempt to achieve the desired result. Another type of tool called an "Optimizer" operates in a similar way, but in this instance it will aim to optimise on a single output value rather than attain any specific value.

The above two techniques may work in simple situations, but are totally unable to deal with the need to look at a number of model output measurement values, perhaps constituting a time sequence. For example, the user may wish to balance profit, company capitalisation, dividend and the number of skilled employees over a period of time. There is no point in maximizing profit at a given time by, for example, asset stripping a company or firing skilled employees, and thereby preventing future profit.

Further disadvantages of the "Solver" and "Optimizer" concepts used in some current spreadsheet applications are:

1) they only produce a single value as a result; and

2) they can only be defined by a mathematical equation.

Another prior art technique is generally referred to as "what-if" programming. Here the user adjusts the input variables, or alternatively instructs the modelling application how to do so, and the user then judges the various outputs produced. This technique can be useful but is almost impossible to use when there are more than four or five input variables. It is difficult to keep track of past experiments, and the user gets distracted by the mechanics of setting up the "what if" experiments.

A book entitled "Evolutionary Art and Computers" written by Stephen Todd and William Latham, Academic Press Limited, 1992, describes a technique developed for computer art which is referred to as "Mutator". The basic Mutator concept is to let the machine randomly alter the input variables of an artistic model, and then to rerun the model with each new randomized set of inputs. The user is then presented with a visual representation of a series of 'mutated' scenarios, and selects the best for a subsequent mutation process; this technique is described in the book as 'breeding'.

In more sophisticated versions of the Mutator concept there are additional features. In one version, the user may judge many of the selections as 'good' or 'bad', and these judgements are then used to 'steer' or bias the mutation. In another version, the user may 'marry' parent selections to produce a child that shares characteristics of its parents. Steering and marriage can permit the user to reach a satisfactory result much more quickly.

Although, through the work of Stephen Todd and William Latham, the mutator principle described above is already known in the field of computer art, the Mutation programs have been, integrated with specific applications in such a way that they cannot be generally applied, ie. they are only designed to operate with a specific application program.

It is an object of the present invention to provide a data processing system with an improved technique for controlling the input variables of a standard or special purpose modelling application.

Accordingly the present invention provides a data processing system for creating drive signals to control an output device, characterised by the combination of: a modelling application in which a model is defined, the model having a plurality of input variables associated therewith; a modification means to determine initial values for the input variables; a model output means for generating the drive signals for the output device based on a state of the model, the state being dependent on the values of said input variables; the modification means being adapted to randomly adjust the values of the input variables within predetermined limits, and to insert the adjusted values into the modelling application to alter the state of the model; the data processing system being programmed to repeat a selected number of times, the generation of drive signals based on states of the model as altered by the modification means; a comparison means for sending the successive drive signals generated by the data processing system to the output device; the modification means being responsive to judgement information input by the user to determine a new set of initial values for the input variables; the data processing system being further programmed to repeat the generation of successive drive signals based on this new set of initial values.

Typically the output device will be a visual display apparatus. However, as discussed later, the output device could instead be a suitable audio or tactile output device rather than a visual one. If the output device is a visual display apparatus then, in preferred embodiments, the model output means is adapted to produce drive signals representing the state of the model in graphical form, the graphical form appearing on the visual display apparatus when the drive signals are sent thereto.

The comparison means can be arranged to operate in one of two ways. In the first mode of operation it is adapted to send the successive drive signals generated by the data processing system to the output device one at a time as they are produced by the model output means. If the output device is a display device this will result in the number of states of the model shown on the screen increasing over time until the selected number of drive signals have been generated. In an alternative mode of operation it will not send any drive signals to the output device until the selected number of drive signals have been generated; then it will send all the drive signals simultaneously.

The present invention can be applied to a large range of modelling applications. Not only can it be used to control a standard modelling application (eg. financial), but it can also be used to control a user written application, eg. a program written to draw a cartoon of a human face; here the invention could be used to allow the user to "mutate" the face to arrive at some desired resemblence. However, in preferred embodiments the modelling application is a software spreadsheet package.

The present invention can be implemented in a number of different ways. For instance if the modelling application is a standard "off-the-shelf" piece of software then the modification means and the comparison means would be supplied as a separate unit. However in certain instances the modelling application, the modification means, the model output means, and the comparison means are incorporated in one package.

The predetermined limits within which the values of the input variables are adjusted can be predefined, or alternatively can be selected by the user. In preferred embodiments the predetermined limits are selected by the user. Typically the values are adjusted by some maximum amount each mutation (hereafter referred to as the 'maximum step'), and the size of the maximum step is then also preferably selected by the user. In addition, the user may alter a 'global mutation rate' that affects the maximum step of all input variables. A high global mutation rate is used for fast and wide searches, and a low rate for final fine tuning of the input variables.

After user judgement has taken place the subsequent adjustment of the values of the input variables can be purely random, or alternatively can be 'steered'. Preferably the adjustment by the modification means is not purely random, but is influenced by the judgement of the user to determine the direction of adjustment. For example if the mutated scenario judged by the user as the best of the scenarios presented to him represented a positive adjustment to one or more of the input variables then the subsequent adjustments by the modification means of such variables would be more likely to be positive adjustments than negative ones.

Viewed from a second aspect the present invention provides a method of operating a data processing system to create drive signals to control an output device, characterised by the combination of the steps of: (a) storing a model in a modelling application, the model having a plurality of input variables associated therewith; (b) employing a modification means to read initial values for the input variables from the modelling application; (c) generating, in a model output means, the drive signals for the output device based on a state of the model, the state being dependent on the values of said input variables; (d) employing the modification means to randomly adjust the values of the input variables within predetermined limits, and then to insert the adjusted values into the modelling application to alter the state of the model; (e) repeating steps (c) and (d) a selected number of times; (f) sending, via a comparison means, the successive drive signals generated by the repeated step (c) to the output device; (g) employing the modification means to determine, based on judgement information input by the user, a new set of initial values for the input variables; and (h) repeating steps (c) to (g).

An important advantage of the present invention is that it provides a data processing system with the ability to use the Mutator principle to control any application that has the relevent characteristics of numeric input variables and sensory (eg. pictorial) output.

Hence the present invention allows standard model building applications, such as existing spreadsheet applications, to be used to define a complex model, where the result of the model is multivariate and may only provide a subjective feel for result correctness. The invention provides a simple way of communicating with such an application to modify the input variables, monitor a sequence of trials and obtain the optimum set of input variables.

Further it can be applied to modelling applications which produce audio or tactile outputs rather than visual output. For example, music is often produced using a technique called FM synthesis. An FM synthesizer has about twenty input that control waveform shape, attack and decay rates, etc. It is very difficult to predict the sound that will result from a given set of inputs. The present invention may be used to generate alternative inputs. Each output may be replayed with perhaps a scale, chord and short tune for user judgement.

Another example is that of a chair or car seat with many controls for back angle, lumbar support, seat height etc. The use of the different controls may interact and a combination can thus be difficult to set, but a sitting user can certainly judge a comfortable combination; thus the present invention may be used to control the settings.

The present invention will be described further, by way of example only, with reference to an embodiment thereof as illustrated in the accompanying drawings, in which:

Figure 1 is a block diagram of a data processing system according to the preferred embodiment of the present invention;

Figure 2 is a flow diagram illustrating the method of operation of the preferred embodiment of the present invention; and

Figure 3 is a graph illustrating the difference in approach between the technique of the present invention and the "Optimizer" and "What-if" techniques of the prior art.

In the preferred embodiment, the present invention is used to enhance a standard financial modelling system. The data processing system of the preferred embodiment consists of two parts, namely:

1) The standard modelling system, which uses a set of input variables to control the state of a model defined within the modelling system. The model will typically define the way in which some process will evolve over time, or will enable some results to be produced at the end of the operation of the process. The results produced by running the modelling system will depend on the input variables and will change to reflect the new state of the model if any of the input variables are altered. These results may be displayed graphically if appropriate.

Provision is made in the data processing system to allow the modelling system to be interrogated to determine the initial state of the set of variables, to change them and to interrogate the final state of the model as a result of those changes.

An example of such a modelling system would be a spreadsheet application running on Windows 3.1 in a PC/DOS or OS/2 environment, which can be interrogated by another application using the Direct Data Exchange (DDE) mechanism of Windows 3.1. Examples of suitable spreadsheet applications are Microsoft Excel, Lotus 123, and Borland's QuatroPro.

2) A controlling application that is able to read the initial set of model input variables from the modelling system, modify them by small random amounts, and then insert these new values of the input variables into the modelling system, thus triggering a new calculation of the model. The calculation results are then retrieved, and displayed for viewing by the user. Typically this process would be repeated automatically a number of times and each set of results displayed, together with the earlier sets, for visual evaluation by the user. When a sufficient number of results are displayed, the user would choose which of the results is closest to the solution desired. This will typically be a subjective choice, not simply dependent on the value of a single number.

Once the user has made a choice, the set of variables for that choice become the new origin of the following set of randomly changed variables. In effect, the user allows the data processing system to make random choices for the variable changes, then steers the path of the changes to move the results of the model calculation in the desired direction, depending on the subjective selection of the "best" of a set of results.

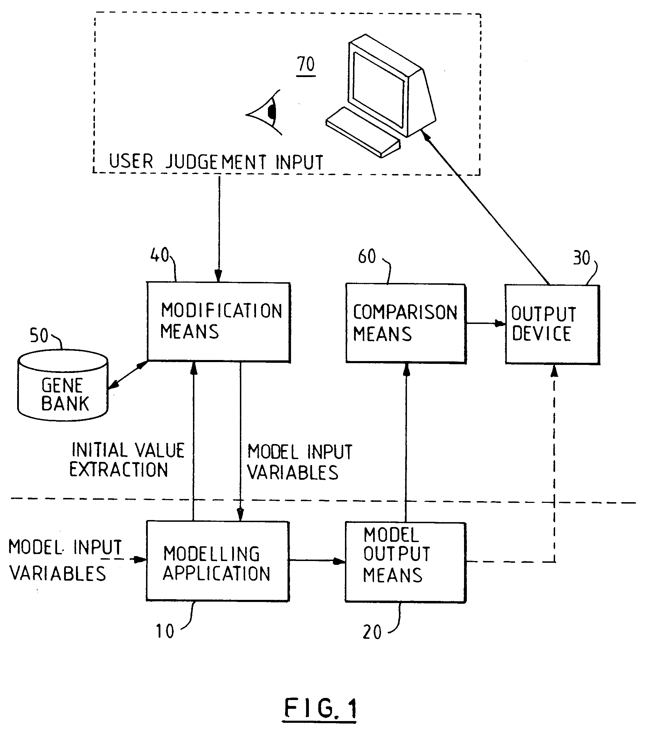

The data processing system of the preferred embodiment will now be described in more detail with reference to Figure 1. The standard modelling system can be considered as two distinct parts. Firstly there is the modelling application 10 in which the financial model is defined. The model will typically be defined by a number of equations, variables and constants, such that alteration of the values of the variables will result in a change in the state of the model. The second part of the modelling system is the model output means 20 which generates drive signals indicative of the state of the model. These drive signals can then be used to control the output device 30. In the preferred embodiment the output device 30 is a display device such as a computer monitor, and in this Instance the drive signals will represent an image for display on the display screen. This image will typically be a graph representing the state of the financial model for a particular set of values of the input variables.

When the modelling application is being operated in its standard mode (ie. mutation facility is not being used) then none of the elements (except for the output device 30) above the dotted line in Figure 1 are used. The input variables are instead entered directly into the modelling application 10, and a new state is created by the modelling application. The model output means 20 then generates drive signals for the display device 30 based on this new state, and these drive signals are passed directly to the display device for presentation to the user.

When the user chooses to apply the mutation facility of the data processing system then the elements above the dotted line in Figure 1 are utilised. The modification means 40 is part of the controlling application mentioned above, and is able to read information from, and insert values for input variables into, the modelling application 10. In the preferred embodiment the user of the system would set the limits within which the value of each input variable can be adjusted by the modification means 40, and would further set the maximum step by which the values are adjusted.

The modification means 40 reads the initial values of the input variables from the modelling application 10, and then stores these values in the gene bank 50. Further the model output means 20 will use the initial values to generate drive signals for the display device 30. These drive signals may be sent to the display device straight away so that the graph corresponding to the initial state of the model is displayed without delay, or alternatively the drive signals can be stored for subsequent transmission to the display device 30.

Once this has been done the modification means 40 will adjust the input variables within the limits set earlier by the user, and store the adjusted values in the gene bank 50; these adjusted values will hereafter be referred to as gene values. This adjustment may be purely random, or alternatively can be weighted ('steered') based on previous results judged by the user as 'good' or 'bad'. The new adjusted values are then inserted into the modelling application 10 to effect a new state of the model. The model output means 20 then creates drive signals based on this new state and these are also sent to the display device or stored with the earlier drive signals for subsequent transmission to the display device.

The formula used for mutation in the preferred embodiment is as follows. Suppose that the n'th gene value for the parent object p is vpn. Let the minimum value for the n'th gene be minn, its maximum be maxn, and its maximum step change rate be dn. Further, let the global mutation rate be mrate. The value for the n'th gene of a child i (vin) is then computed as follows:

$$vin = vpn + (rin \times dn \times mrate)$$
$$vin = max(minn, vin)$$
$$vin = min(maxn, vin)$$

where rin is a random number $-1 < rn < 1$ generated for the n'th gene value of the i'th child.

The modification means 40 repeats this mutation process a number of times until a selected number of states of the model have been created. Then the drive signals are sent to the display device by the output comparison means 60 (if they have been stored rather than displayed 'on the fly') so that all of the graphs are displayed simultaneously. The user can then subjectively judge which one (or more) of the states (as represented by the graphs) best represents what he is looking for, and can use a selection device such as a mouse to select these graphs. This selection information 70 is fed back to the modification means 40, which then retrieves the relevant gene values from the gene bank 50. These then form the initial values of the input variables for the next iteration of the mutation process.

If more than one state has been selected by the user then gene values for the children are selected by a 'marry' operation, with the selected states as 'parents'. Various forms of marry operation may be used to generate each child. In one form, each gene value for the child is selected from the corresponding gene value of one of the parents, with an independent random selection of parent for each gene. In another, the genes from two parents are spliced after the nth gene position. The first 'n' genes are taken from one parent, and the remaining genes are taken from the other. The selection of the value 'n' is random between 1 and the total number of genes less one - there must be at least one gene from each parent or else the child will be an exact copy of the parent. The selection of which parent is to be used before the splice and which is to be used after the splice is also taken at random.

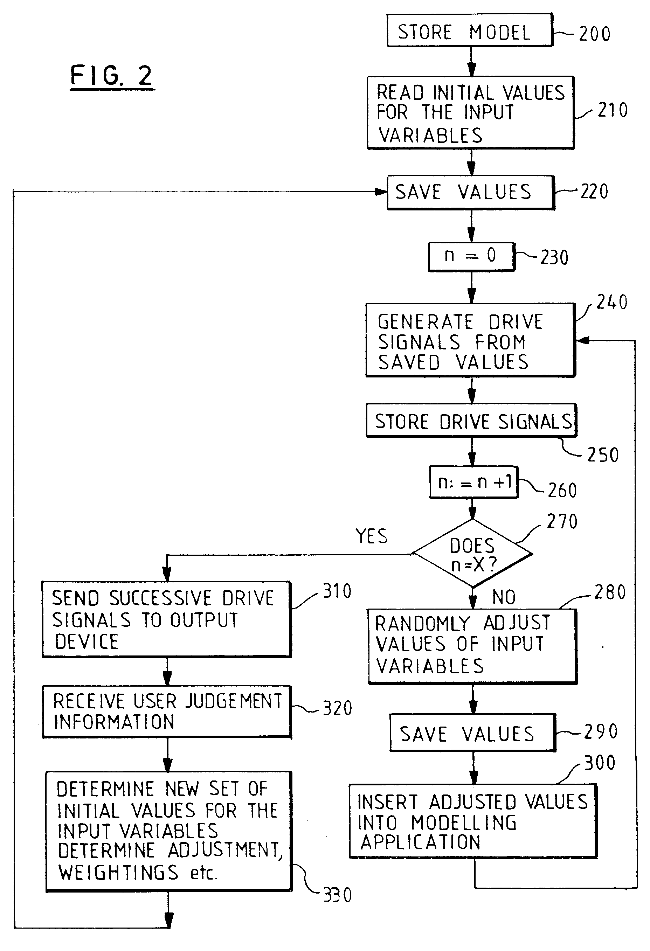

The method of operation of the data processing system of the preferred embodiment will now be described further with reference to Figure 2.

At step 200 a model is defined and stored in the modelling application 10. As an example the model could be that of a small company building widgets and selling on the open market, and could be defined in Microsoft's Excel spreadsheet application.

Once the user has selected the mutation facility provided by the data processing system of the preferred embodiment, then the initial values for the input variables are read by the modification means 40 (at step 210), and stored in the gene bank (step 220). The modification means may also read the predetermined limits within which the values of the input variables may be adjusted, and the maximum step amount, at this stage. A variable 'n' is used to count the number of sets of drive signals that have been generated (ie. the number of states of the model to be displayed), and is reset to zero at step 230.

At step 240 the values saved at step 220 are used by the model output means to generate drive signals for the display device, and these drive signals are then stored at step 250 for subsequent transmission to the display device. Following this the value of 'n' is incremented by one (step 260) and it is determined whether 'n' then equals a selected number 'X' (step 270). 'X' will typically have been chosen by the user since the user will decide how many states of the model he wants to be presented with before entering any judgement information. As a suitable example, the user may wish to view a set of eight graphs, one for each of eight sets of model input parameters, plus a further graph illustrating the initial state. In this situation a total of nine sets of drive signals will be needed, and so 'X' will be set to nine.

If 'n' does not equal 'X' the process proceeds to step 280, where the modification means 40 is employed to randomly adjust the values of the input variables within the predetermined limits. As already mentioned the adjustments may be truly random, or may be 'steered'. These adjusted values are then stored (at step 290) in the gene bank 50, and inserted into the modelling application 10 (at step 300).

At this point the process returns to step 240 and another set of drive signals are generated. This loop is repeated until it is determined at step 270 that 'n' now equals 'X'. When this condition is met the comparison means 60 sends the successive drive signals (that had been stored at step 250) to the display device 30 (step 310). The display device then produces nine graphs at different locations on the display screen so that the user can view them simultaneously.

Once the user has studied them lie will use an input device such as a mouse to select one or more of the graphs for subsequent mutation. This user judgement information 70 is received by the modification means 40 at step 320. If only one graph is selected then the modification means simply retrieves the gene values corresponding to that graph and uses them as the initial set of values of the input variables for the subsequent mutation process; steps 220 through 330 are then repeated. However if the user has selected more than one graph then he can choose one of a number of ways in which to combine the various gene values of the different graphs, eg. by 'marrying' as discussed earlier. By making use of the 'marry' facility the user is able to control the direction of variable changes more tightly, and so can obtain the optimum set of variables with fewer iterations.

Further the modification means 40 can be set such that it analyses the user judgement information on selected objects. In the preferred embodiment the following analysis takes place:

Suppose that in the previous step, the value for the n'th gene of the parent was vpn, and the value for the n'th gene of the i'th child was vin. The system keeps a 'steering' vector, with the n'th element sn giving a bias for the n'th gene.

Initially, all the sn are set to 0. When a user selects object i as good, the system recalculates the steering vector for each gene position as follows:

$$sn = sn + vin - vpn.$$

When a user selects object i as bad, the system recalculates the steering vector for each gene position as follows:

$$sn = sn - vin + vpn.$$

When object j is chosen for breeding, a new parent object q is made using the gene values for object j, steered by the corresponding values in s. Thus the genes for object q are set for each gene position n by the follwing equation:

$$vqn = vjn + sn.$$

This new object q is used as the base object for the next set of mutations.

The steering may be damped by a factor alpha ($0 <$ alpha $<= 1$) to prevent overreaction to user judgements, by using the following equation:

$$vqn = vjn + (alpha \times sn).$$

Typically, a value of alpha of around 0.5 is used. Alpha may also be derived from the global mutation rate.

The user can repeat the mutation process as many times as he desires until he has a result which he is happy with. If the user decides that his earlier judgements were wrong he can 'back out' through the various levels of mutation, and then restart from a desired point. In a preferred embodiment the data processing system is provided with a facility to illustrate the path that the user has taken by displaying a tree structure on the screen with each mutation forming a node on the tree.

Communication to the modelling system is via the DDE concept in the preferred embodiment, here used to interrogate and change the variables and retrieve the resulting graph generated to depict the model calculation results. However other techniques can be used to communicate between the controlling application and the modelling system.

The preferred embodiment of the present invention can be applied to modelling applications other than financial spreadsheet applications. Although it will be particularly useful in the area of spreadsheet applications, it also can be seen to be applicable to standard design packages, Identikit applications, etc.

As can be seen from the above description, the preferred embodiment of the invention enables a single controlling application, that can communicate with one or more subsidiary applications (the modelling system), to control a set of input variables that define the way in which the modelling system functions. The flow of data is bi-directional and may include the ability to request drawings or business charts created as a result of the variable changes and depicting the results of the activities of the modelling system. The data generated by the controlling application, and input to the modelling system, is derived from subjective end user judgements on the output of the modelling system. With graphical output, this system provides greatly enhanced data to the user, enabling his judgement to be far more informed and effective.

The controlling application described above is multi-purpose and, except for assumptions on the method of communication (eg. use of DDE in a Windows 3.1 environment (N.B. will also work on OS/2 and the future NT systems) or sockets with Unix/AIX), is not dependent on the subsidiary system function. Further the communication method is operating system specific, but not application specific.

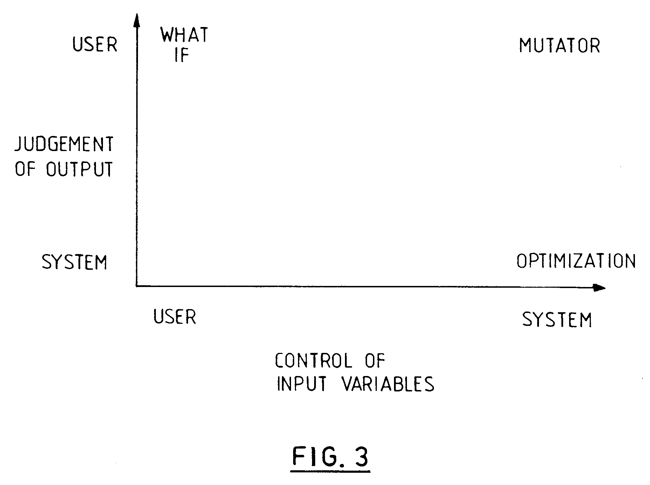

Figure 3 illustrates the difference in approach between a controlling application employing the mutator principle of the preferred embodiment, and the prior art 'optimization' and 'what-if' programming techniques. When using the mutator principle the data processing system has complete control of the changes made to the input variables, and the user makes a judgement of the output produced by such variable changes. With the optimization technique the data processing system again controls the input variables but there is no user judgement of the output. The user chooses the aspect of the model that he wishes to optimize but the actual output is controlled by the system; there is no means for passing user judgement of the output back into the system. With the what-if programming technique the user does judge the output, but also has to control the input variables. This is a big disadvantage when one is attempting to keep track of many input variables at the same time.

## Claims

1. A data processing system for creating drive signals to control an output device, characterised by the combination of:

   a modelling application in which a model is defined, the model having a plurality of input variables associated therewith;

   a modification means to determine initial values for the input variables;

   a model output means for generating the drive signals for the output device based on a state of the model, the state being dependent on the values of said input variables;

   the modification means being adapted to randomly adjust the values of the input variables within predetermined limits, and to insert the adjusted values into the modelling application to alter the state of the model;

   the data processing system being programmed to repeat a selected number of times, the generation of drive signals based on states of the model as altered by the modification means;

   a comparison means for sending the successive drive signals generated by the data processing system to the output device;

   the modification means being responsive to judgement information input by the user to determine a new set of initial values for the input variables;

   the data processing system being further programmed to repeat the generation of successive drive signals based on this new set of initial values.

2. A data processing system as claimed in Claim 1, wherein the output device is a visual display apparatus.

3. A data processing system as claimed in Claim 2, wherein the model output means is adapted to produce drive signals representing the state of the model in graphical form, the graphical form appearing on the visual display apparatus when the drive signals are sent thereto.

4. A data processing system as claimed in any of claims 1 to 3, wherein the comparison means sends the successive drive signals generated by the data processing system to tie output device one at a time as they are produced by the model output means.

5. A data processing system as claimed in any of claims 2 to 4, wherein the modelling application is a software spreadsheet package.

6. A data processing system as claimed in any preceding claim, wherein the modelling application, the modification means, the model output means, and the comparison means are incorporated in one package.

7. A data processing system as claimed in any preceding claim, wherein the predetermined limits within which the values of the input variables are adjusted by the modification means are selected by the user.

8. A data processing system as claimed in claim 7, wherein the values of the input variables are adjusted by a maximum amount between the generation of successive drive signals, this maximum amount being selected by the user.

9. A data processing system as claimed in any preceeding claim, wherein the adjustment of the values by the modification means is not purely random but is influenced by the judgement of the user to determine the direction of adjustment.

10. A method of operating a data processing system to create drive signals to control an output device, characterised by the combination of the steps of:
    (a) storing a model in a modelling application, the model having a plurality of input variables associated therewith;
    (b) employing a modification means to read initial values for the input variables from the modelling application;
    (c) generating, in a model output means, the drive signals for the output device based on a state of the model, the state being dependent on the values of said input variables;
    (d) employing the modification means to randomly adjust the values of the input variables within predetermined limits, and then to insert the adjusted values into the modelling application to alter the state of the model;
    (e) repeating steps (c) and (d) a selected number of times;

    (f) sending, via a comparison means, the successive drive signals generated by the repeated step (c) to the output device;
    (g) employing the modification means to determine, based on judgement information input by the user, a new set of initial values for the input variables; and
    (h) repeating steps (c) to (g).

11. A method of operating a data processing system to create drive signals to control an output device, characterised by the combination of the steps of:
    (a) storing a model in a modelling application, the model having a plurality of input variables associated therewith;
    (b) employing a modification means to read initial values for the input variables from the modelling application;
    (c) generating, in a model output means, the drive signals for the output device based on a state of the model, the state being dependent on the values of said input variables;
    (d) sending, via a comparison means, the successive drive signals generated by the repeated step (c) to the output device;
    (e) determining within the modification means, based on judgement information input by the user, a new set of initial values for the input variables;
    (f) employing the modification means to randomly adjust the values of the input variables within predetermined limits, and to then insert the adjusted values into the modelling application to alter the state of the model;
    (g) repeating steps (c) to (f).

12. A method as claimed in Claim 10 or Claim 11, wherein the output device is a visual display apparatus.

13. A method as claimed in Claim 12, wherein the model output means is adapted to produce drive signals representing the state of the model in graphical form, the graphical form appearing on the visual display apparatus when the drive signals are sent thereto.

14. A method as claimed in Claim 12 or Claim 13, wherein the modelling application is a software spreadsheet package.

15. A method as claimed in any of claims 10 to 14, wherein the predetermined limits within which the values of the input variables are adjusted by the modification means are selected by the user.

**16.** A method as claimed in any of claims 10 to 15, wherein the values of the input variables are adjusted by a maximum amount between the generation of successive drive signals, this maximum amount being selected by the user.

**17.** A method as claimed in any of claims 10 to 16, wherein the adjustment of the values is not purely random but is influenced by the judgement of the user to determine the direction of adjustment.

**18.** A method as claimed in any of claims 10 to 17, wherein the successive drive signals generated by the repeated step (c) are sent to the output device one at a time by the comparison means as they are produced by the model output means.

USER JUDGEMENT INPUT

70

40

MODIFICATION
MEANS

50

GENE
BANK

60

COMPARISON
MEANS

30

OUTPUT
DEVICE

INITIAL VALUE
EXTRACTION

MODEL INPUT
VARIABLES

MODEL INPUT
VARIABLES

MODELLING
APPLICATION

MODEL
OUTPUT
MEANS

10

20

FIG. 1

FIG. 2

STORE MODEL — 200

READ INITIAL VALUES FOR THE INPUT VARIABLES — 210

SAVE VALUES — 220

$n = 0$ — 230

GENERATE DRIVE SIGNALS FROM SAVED VALUES — 240

STORE DRIVE SIGNALS — 250

$n: = n + 1$ — 260

DOES $n = X$? — 270

YES

SEND SUCCESSIVE DRIVE SIGNALS TO OUTPUT DEVICE — 310

RECEIVE USER JUDGEMENT INFORMATION — 320

DETERMINE NEW SET OF INITIAL VALUES FOR THE INPUT VARIABLES DETERMINE ADJUSTMENT, WEIGHTINGS etc. — 330

NO

RANDOMLY ADJUST VALUES OF INPUT VARIABLES — 280

SAVE VALUES — 290

INSERT ADJUSTED VALUES INTO MODELLING APPLICATION — 300

11

FIG. 3